# DEMANDE DE BREVET EUROPEEN

(11) **EP 4 015 676 A1**
(43) Date de publication de la demande: **22.06.2022**
(21) Numéro de dépôt: 21215582.4
(22) Date de dépôt: 17.12.2021
(51) Int. Cl.: C30B 23/06, C23C 14/24, C30B 29/12, C30B 29/54, C23C 14/06

(54) **PROCÉDÉ DE DÉPÔT D'UNE COUCHE DE PÉROVSKITE ORGANIQUE OU HYBRIDE ORGANIQUE/INORGANIQUE**

(30) Priorité: 21.12.2020 FR 2013841
(71) Demandeur: Commissariat à l'énergie atomique et aux énergies alternatives, 75015 Paris (FR)
(72) Inventeur: GRENET, Louis, 38054 Grenoble Cedex 09 (FR); EMIEUX, Fabrice, 38054 Grenoble Cedex 09 (FR); VERILHAC, Jean-Marie, 38054 Grenoble Cedex 09 (FR)
(74) Mandataire: Brevalex

(57) **Abrégé**

Procédé de dépôt d'une couche de pérovskite organique ou hybride organique/inorganique (1) sur un substrat comprenant les étapes suivantes :
a) fournir un substrat (10) et une cible organique ou hybride organique/inorganique,
b) positionner le substrat (10) et la cible, dans un four de sublimation à faible distance (100),
c) déposer une couche de pérovskite organique ou hybride organique/inorganique (1) sur le substrat (10) par sublimation de la cible,
l'écart de température entre la cible et le substrat (10) étant, de préférence, compris entre 50°C et 350°C, encore plus préférentiellement entre 50°C et 200°C,
l'épaisseur de la couche de pérovskite organique ou hybride organique/inorganique (1) déposée étant, de préférence, comprise entre 50 nm et 5000 µm.

## Description

### DOMAINE TECHNIQUE

La présente invention se rapporte au domaine général des procédés de dépôt de couches de pérovskites organiques ou hybrides organiques/inorganiques.

L'invention trouve des applications dans de nombreux domaines industriels, en particulier dans le domaine de la détection X pour le médical, la sûreté, la sécurité, la radioprotection, ou les grands instruments scientifiques) , mais aussi dans le domaine du photovoltaïque, de la détection de rayonnement gamma, de rayonnements ionisants (alpha, beta, neutron) ou encore pour la fabrication de dispositifs électroniques, optiques ou optoélectroniques, en particulier pour la fabrication de diodes électroluminescentes (DEL), de photo-détecteurs, de scintillateurs ou encore de transistors.

L'invention est particulièrement intéressante puisqu'elle permet de déposer des couches de pérovskites dans une très large gamme d'épaisseurs, allant des couches minces (épaisseur typiquement comprise entre 10nm et 10 µm) aux couches épaisses (épaisseur typiquement supérieure ou égale à 10µm voire supérieure à 1 mm). Un bon contrôle de la qualité des couches pour des temps de dépôt raisonnables (> 6h) est possible dans la gamme d'épaisseur 10 nm - 5 mm.

### ÉTAT DE LA TECHNIQUE ANTÉRIEURE

Les matériaux pérovskites (PVK) organiques ou hybrides organique/inorganique de type ABX₃ sont particulièrement intéressants pour les applications dans le domaine du photovoltaïque (PV), des LEDs, des photodétecteurs dans les gammes du visible ou du proche infrarouge, ou encore pour la détection des rayonnements X et gamma.

Ces matériaux hybrides peuvent être obtenus par de nombreuses méthodes [1] : croissance en solution, dépôt à la tournette (« spin-coating »), ablation laser pulsé (ou PLD pour « Pulsed Laser Deposition »), dépôt séquentiel en phase vapeur (« Sequential Vapor Deposition »), dépôt par bain chimique (CBD pour « Chemical Bath Déposition »), etc.

Parmi ces méthodes, il est, par exemple, possible de synthétiser des cristaux de pérovskites de formule MAPbBr₃ selon les étapes suivantes : dissoudre des précurseurs CH₃NH₃Br et PbBr₂ dans du DMF sous ultra-sons, filtrer la solution ainsi obtenue, puis placer le filtrat dans un bain d'huile à 80°C pendant 4h [2].

Des cristaux de formule ODABCO-NH₄Cl₃, ODABCO-NH₄Br₃ et MDABCO-NH₄I₃ ont également été synthétisés par évaporation lente, sur plusieurs jours, d'une solution contenant les précurseurs de ces matériaux [3].

Selon un autre exemple, des pérovskites hybrides organique/inorganique de formule AMX₃ peuvent être obtenues par sublimation à faible distance (ou CSS pour « Close Space Sublimation ») [4]. Pour cela, il faut dans un premier temps déposer, sur un substrat, une couche de précurseur inorganique MX₂ avec X avec un ion halogénure et M un cation d'un métal divalent, et fournir une source A de matériau organique (par exemple CH₃NH₃⁺). La couche de précurseur a une épaisseur, par exemple, de 30nm à 500nm. La source a, par exemple, une épaisseur de 1mm. Puis la couche de précurseur et la source sont chauffées. Seule, la partie organique est sublimée. Le matériau pérovskite est obtenu par diffusion solide de la partie organique dans les précurseurs inorganiques.

Cependant, avec un tel procédé, il n'est pas possible de former des couches épaisses de pérovskites.

### EXPOSÉ DE L'INVENTION

Un but de la présente invention est de proposer un procédé de dépôt d'une couche de pérovskite organique ou hybride organique/inorganique, sur un substrat, le procédé étant simple à mettre en œuvre, permettant de former des couches d'épaisseur variable (typiquement d'une dizaine de nanomètre à des épaisseurs supérieures ou égales à 5 mm), homogènes à la fois dans l'épaisseur et en surface, sur de grandes surfaces, en un temps raisonnable (inférieur à une journée et de préférence inférieur à 6h).

Pour cela, la présente invention propose un procédé de dépôt d'une couche de pérovskite organique ou hybride organique/inorganique comprenant les étapes suivantes :
a) fournir un substrat et une cible organique ou hybride organique/inorganique,
b) positionner le substrat et la cible, dans un four de sublimation à faible distance,
c) déposer une couche de pérovskite organique ou hybride organique/inorganique sur le substrat par sublimation de la cible.

L'invention se distingue fondamentalement de l'art antérieur par le dépôt d'une couche de matériau pérovskite tout organique ou hybride organique/inorganique par sublimation à faible distance (CSS) en une seule étape. Le matériau de la cible comprenant tous les éléments de la pérovskite que l'on cherche à obtenir, il n'y a pas obligatoirement besoin de former préalablement sur le substrat une couche de précurseur.

Les couches de pérovskites ainsi obtenues ont une épaisseur uniforme et des caractéristiques homogènes sur toute la surface de dépôt. Le procédé est reproductible et peut être utilisé pour déposer des couches de pérovskites sur des surfaces de dimensions variées, par exemple de 1cm² à plus de 1m².

En fonction de la durée et de la température de dépôt on peut obtenir des couches de fortes épaisseurs (typiquement supérieures ou égales à 0,1 mm par exemple de 0,1 mm à 3mm, voire de 0,1 mm à 5 mm), d'épaisseurs intermédiaires ou moyennes (typiquement de 2 µm à moins de 0,1 mm) ou encore de faibles épaisseurs (typiquement inférieures à 2 µm).

Ce procédé est particulièrement intéressant pour les dépôts de couches épaisses (typiquement d'épaisseurs supérieures ou égales à 0,1 mm) devant être mis en œuvre à des températures modérées (typiquement inférieures à 250°C).

Avantageusement la couche de pérovskite organique ou hybride a une épaisseur comprise entre 50nm et 5000 µm. Par exemple, pour les applications de type PV, LED, détection IR, les épaisseurs visées seront de l'ordre de quelques dizaines de nanomètres à une dizaine de micromètres (typiquement de 50 nm à 10000 nm), tandis que pour la détection de rayons X et gammas, les épaisseurs visées seront de l'ordre de plusieurs dizaines de micromètres à plusieurs milliers de micromètres (de 10 µm à 5000 µm).

Selon une première variante de réalisation avantageuse, la couche de pérovskite organique ou hybride organique/inorganique a pour formule ABX₃

A est un composé organique, un mélange de composés organiques ou un mélange de composé organique et de composé inorganique. Par composé organique, nous entendons tout composé contenant au moins l'élément carbone et un ou plusieurs des éléments suivants : hydrogène, halogène, oxygène, soufre, phosphore, silicium ou azote.

Par exemple, A représente :
- une molécule organique : par exemple CH₃NH₃⁺ (methylammonium MA) ou CH(NH₂)₂⁺ (formamidinium FA), ou C(NH2)3⁺(guanidinium GA)
- un mélange de molécules organiques (par exemple : MA₁₋ₓFAₓ avec 0<x<1), ou
- un mélange de parties organique (par exemple MA, FA) et inorganique (par exemple Cs, Rb, K, Li, Na,...), (par exemple : Cs₁₋ₓFAₓ avec 0<x<1),

B un élément simple inorganique (par exemple Pb, Sn, Ge, Si...), une molécule organique (telle que N-méthyl-1,4-diazabicyclo[2.2.2]octane) (MDABCO) ou N-hydroxy-N'-diazabicyclo[2.2.2]octonium (ODABC)), un mélange de plusieurs éléments inorganiques (par exemple un alliage tel que Sn_{0.5}Pb_{0.5}) et/ou molécules organiques,
X un anion de préférence, un halogénure (par exemple X=Cl⁻, Br⁻, I⁻, F⁻...). Selon cette première variante de réalisation, la couche de pérovskite organique ou hybride organique/inorganique est, de préférence, en MAPbBr₃.

Encore plus préférentiellement, la couche de pérovskite est en MAPbBr₃ et a une épaisseur comprise entre 500 µm et 2mm.

Selon ces différentes variantes de réalisation, il est également possible d'avoir des mélanges de 2 à 5 éléments sur chaque site X (par exemple du type X=ClₖBrₗI₁₋ₖ₋ₗ avec 0≤k,l≤1 et 0≤k+l≤1). Il en va de même pour les sites A et B.

On peut généraliser en disant que la couche de pérovskite organique ou hybride organique/inorganique a pour formule A⁽¹⁾_{1-(y2+...+yn)}A⁽²⁾_{y2}...A⁽ⁿ⁾_{yn}B⁽¹⁾_{1-(z2+...+zm)}B⁽²⁾_{z2}...B^{(m)}_{zm}X⁽¹⁾_{3-(x2+...+xp)}X⁽²⁾ₓ₂...X^{(p)}ₓₚ. La couche de pérovskite organique ou hybride organique/inorganique a, par exemple, pour formule Cs_{0.17}FA_{0.83}Pb(Br_{0.17}I_{0.83})₃.

Selon une deuxième variante de réalisation avantageuse, la couche de pérovskite organique ou hybride organique/inorganique a pour formule A₂C¹⁺D³⁺X₆.

avec A est un composé organique, un mélange de composés organiques ou un mélange de composé organique et de composé inorganique tel que défini précédemment,

C et D sont des cations. C peut être choisi, par exemple, parmi Ag, Au, Tl, Li, Na, K, Rb et/ou D peut être choisi, par exemple, parmi Al, Ga, In, Sb, Bi.

X est un anion, de préférence, un halogénure (par exemple X=Cl⁻, Br⁻, I⁻, F⁻ ...).

Selon cette deuxième variante de réalisation, la couche de pérovskite organique ou hybride organique/inorganique a, de préférence, pour formule MA₂AgBiBr₆.

Selon une troisième variante de réalisation, la couche de pérovskite organique ou hybride organique/inorganique est de type Ruddlesden-Popper aussi communément appelé pérovskites 2D, avec par exemple la formule (RNH₃)₂Aₙ₋₁BₙX₃ₙ₊₁ (n = 1, 2, 3, 4......), avec R une chaine aliphatique et/ou aromatique carbonée, et

A :
- une molécule organique : par exemple CH₃NH₃⁺ (methylammonium MA) ou CH(NH₂)₂⁺ (formamidinium FA), ou C(NH2)3⁺(guanidinium GA)
- un mélange de molécules organiques (par exemple : MA₁₋ₓFAₓ avec 0<x<1), ou
- un mélange de parties organique (par exemple MA, FA) et inorganique (par exemple Cs, Rb, K, Li, Na,...), (par exemple : Cs₁₋ₓFAₓ avec 0<x<1),

B :
un élément simple inorganique (par exemple Pb, Sn, Ge, Si...), une molécule organique (telle que N-méthyl-1,4-diazabicyclo[2.2.2]octane) (MDABCO) ou N-hydroxy-N'-diazabicyclo[2.2.2]octonium (ODABC)), un mélange de plusieurs éléments inorganiques (par exemple un alliage tel que Sn_{0.5}Pb_{0.5}) et/ou molécules organiques,

X :
X un anion de préférence, un halogénure (par exemple X=Cl⁻, Br⁻, I⁻, F⁻...).

Selon un mode de réalisation particulier, la cible est formée de particules.

Selon une variante de ce mode de réalisation particulier, la cible comprend des particules de formule ABX₃.

Selon une autre variante de ce mode de réalisation particulier, la cible comprend un mélange de particules binaires de différentes natures, par exemple un mélange MABr, BiBr₃ et AgBr, le mélange pouvant en outre comprendre des particules tertiaires, par exemple la cible comprend des particules de formule AX, de particules de formule BX₂ et éventuellement des particules de formule ABX₃.

Selon un mode de réalisation avantageux, la cible est une cible solide, formée de particules agglomérées et/ou frittées. Cette variante permet de fabriquer des couches de pérovskites de faibles, moyennes ou fortes épaisseurs. Cette variante est particulièrement avantageuse pour former des couches de pérovskites de fortes épaisseurs.

Selon un autre mode de réalisation avantageux, les particules forment un lit de poudre. Cette variante est particulièrement avantageuse pour former des couches de pérovskites de faibles ou moyennes épaisseurs.

Selon un mode de réalisation particulier, la cible est une cible solide formée d'un film de pérovskite organique ou hybride organique/inorganique. Un tel film est déposé, par exemple, sur un substrat en verre. Avec une telle cible, il est possible de fabriquer des couches de pérovskites de faibles, moyennes ou fortes épaisseurs. Cette variante est particulièrement avantageuse pour former des couches de pérovskites de faibles épaisseurs. La cible peut être utilisée pour plusieurs dépôts successifs.

Avantageusement, la cible fournie à l'étape a) est obtenue selon les étapes suivantes :
- mécanosynthèse par co-broyage d'un premier matériau de formule AX et d'un deuxième matériau de formule BX₂ de manière à obtenir une poudre de formule ABX₃,
- pressage de la poudre de formule ABX₃ pour obtenir une cible solide de formule ABX₃. Selon un mode de réalisation avantageux, le pressage de la cible solide peut se faire en chauffant la poudre.

Avantageusement, avant l'étape c), le procédé comprend une étape additionnelle au cours de laquelle la cible est chauffée à une température allant de 50°C à 500°C et est soumise à une pression supérieure à 10³ Pa. Lors de cette étape, la cible n'est pas sublimée. Cette haute pression conduit à une interdiffusion des éléments en présence, et ainsi à la formation de particules de formule ABX₃ et/ou à l'agglomération des particules de la cible. Ainsi, lorsque la cible est formée de particules de formule AX et des particules de formule BX₂, il est possible de former *in situ* la phase ABX₃ dans la cible. Cette étape est réalisée sous atmosphère neutre, par exemple sous argon ou sous azote. Une telle étape est, avantageusement, réalisée dans le four de sublimation à faible distance, entre l'étape b) et l'étape c).

Avantageusement, lors de l'étape c), l'écart de température entre la cible et le substrat est compris entre 10°C et 350°C et de préférence entre 50°C et 200°C.

Selon une variante particulière de réalisation, l'étape c) est réalisée à une pression P inférieure à 1 Pa, et de préférence inférieure à 0,1 Pa.

Selon une autre variante particulière de réalisation, l'étape c) est réalisée sous atmosphère réductrice ou sous atmosphère oxydante.

De préférence, pour former des couches épaisses, on choisira un substrat dont le coefficient de dilatation thermique est proche de celui de la couche de pérovskite organique ou hybride organique/inorganique à déposer. Par proche, on entend que leurs coefficients de dilatation thermique ne varient pas de plus de 25%, et de préférence, ils ne varient pas de plus de 10 %. Avantageusement, le substrat est une matrice en TFT (« Thin Film Transistor ») déposée sur un support par exemple en verre, en silicium ou en polyimide.

Avantageusement, avant l'étape c), le procédé comprend une étape additionnelle au cours de laquelle une couche intermédiaire, de nature identique ou différente à la couche de pérovskite organique ou hybride organique/inorganique, est déposée sur le substrat afin d'améliorer la qualité de la couche principale et/ou le fonctionnement du dispositif final. La couche intermédiaire peut :
- jouer le rôle de couche d'accroche, et/ou
- aider à la cristallisation en favorisant une homoépitaxie ou une hétéroépitaxie de la couche de pérovskite organique ou hybride organique/inorganique, et/ou
- assurer un bon contact électrique entre le substrat et la couche de pérovskite organique ou hybride organique/inorganique, et/ou
- avoir des propriétés optoélectroniques, et/ou
- jouer le rôle de couche tampon afin de compenser la différence de coefficient de dilatation thermique entre la couche principale et le substrat.

Le procédé présente au moins un ou plusieurs des avantages suivants :
- obtenir une cible ayant directement la bonne phase cristallographique,
- former des couches de pérovskites organiques ou hybrides de faibles, intermédiaires ou fortes épaisseurs,
- former des couches homogènes dans l'épaisseur sur l'ensemble du dépôt,
- former des couches de pérovskites organiques ou hybrides sur de grandes surfaces (de plus quelques dizaines de cm²),
- contrôler la vitesse de dépôt sur une très large gamme (typiquement de quelques nm/min à quelques dizaines de µm/min), voire jusqu'à 1000 µm/h,
- le procédé est réalisé sur des temps raisonnables (de préférence inférieurs à 5h et, encore plus préférentiellement inférieurs à 2h), puisque la vitesse de dépôt est correctement contrôlable entre 1 nm/min et 10 µm/min (de 0.1 nm/min à 50 µm/min),
- le procédé est mis en œuvre à des températures de substrat modérées (inférieures à 350°C, de préférence inférieures à 250°C et encore plus préférentiellement inférieures à 200°C), ce qui permet d'utiliser une large gamme de substrats et/ou de supports (matrice TFT, silicium, verre, polymère...),
- le dépôt par CSS permet un fort taux d'utilisation de la matière (au moins 80% de la matière est sublimée, et notamment jusqu'à 90% voire jusqu'à 99% de matière sublimée est déposée) par rapport à d'autres méthode de dépôt sous vide pour lesquelles seulement 20 à 50% de la matière est déposée (typiquement 30% pour les méthodes classiques de dépôt par évaporation), ce qui réduit ainsi les coûts de fabrication,
- le procédé est reproductible et applicable à grande échelle,
- les couches de pérovskites obtenues présentent une bonne pureté (le dépôt CSS est plus pur que la cible, les impuretés n'étant généralement pas sublimées) ; de plus, en se plaçant sous la température de fusion de la cible, le dépôt par CSS purifie d'avantage le matériau que par évaporation.

L'invention concerne également un empilement comprenant un substrat et une couche de pérovskite organique ou hybride organique/inorganique obtenue par un procédé tel que décrit précédemment, la couche de pérovskite organique ou hybride organique/inorganique étant en MAPbBr₃ (ayant de préférence une épaisseur comprise entre 500 µm et 2mm), en Cs_{0.17}FA_{0.83}Pb(Br_{0.17}I_{0.83})₃ ou en MA₂AgBiBr₆.

La couche de pérovskite organique ou hybride organique/inorganique a, de préférence, une épaisseur supérieure ou égale à 0,1µm. Par exemple, elle a une épaisseur supérieure à 0,1mm.

De préférence, la couche de pérovskite organique ou hybride organique/inorganique a une épaisseur de 1 à 10 mm. Une telle couche est particulièrement intéressante pour les applications de détection de rayonnement X ou gamma.

L'invention concerne également l'utilisation d'un empilement tel que défini précédemment dans le domaine médical (par exemple pour la détection X) ou dans le domaine photovoltaïque (par exemple dans une cellule pérovskite ou dans un module tandem comprenant une cellule à hétérojonction de silicium et une cellule pérovskite).

En particulier, on utilisera, avantageusement, une couche de MAPbBr₃ dans le domaine médical, en particulier pour l'imagerie X ou pour la détection de rayonnement gamma. Par exemple, on utilisera :
- une couche de MAPbBr₃ d'une épaisseur d'environ 200 µm pour la mammographie X,
- une couche de MAPbBr₃ d'une épaisseur d'environ 1mm pour la radiographie X (main, thorax,...),
- une couche de MAPbBr₃ d'une épaisseur d'environ 2mm pour la scintigraphie.

Une couche de Cs_{0.17}FA_{0.83}Pb(Br_{0.17}I_{0.83})₃ de 400 nm pourra être utilisée, par exemple, pour fabriquer des modules photovoltaïques, en particulier pour fabriquer des modules tandem à large bande d'énergie interdite comme des tandems comprenant une cellule inférieure en silicium à hétérojonction et une cellule supérieure en pérovskite.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
[Fig. 1] représente, de manière schématique en coupe, une couche de pérovskite organique ou hybride organique/inorganique déposée sur un substrat selon un mode de réalisation particulier de l'invention.
[Fig. 2] représente, de manière schématique en coupe, un empilement comprenant un support, un substrat et une couche de de pérovskite organique ou hybride organique/inorganique selon un mode de réalisation particulier de l'invention.
[Fig. 3] représente, de manière schématique en coupe, un empilement comprenant un support, un substrat, une couche intermédiaire et une couche de pérovskite organique ou hybride organique/inorganique selon un mode de réalisation particulier de l'invention.
[Fig. 4] représente, de manière schématique, et en coupe, un four de CSS selon un mode de réalisation particulier de l'invention.
[Fig. 5] représente, de manière schématique, et en coupe, un suscepteur et un couvercle d'un four de CSS selon un mode de réalisation particulier de l'invention.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Bien que cela ne soit aucunement limitatif, l'invention est particulièrement intéressante pour la fabrication de dispositifs électroniques, optique ou optoélectroniques à base de pérovskite organique ou hybride organique/inorganique. Par exemple, il peut s'agir de LEDs, de cellules photovoltaïques, de détecteurs (infrarouge, rayonnement X, rayonnement gamma, ...), de capteurs (ferroélectriques, pyroélectrique), ou d'actuateurs (piézoélectriques).

L'invention trouve des applications dans les domaines suivants :
- détection de rayonnement X pour le médical, notamment pour les applications centrées sur la mammographie (détection d'un rayonnement centré autour de 18-20 keV, norme IEC 62220-1-2:2007), imageur pour la radiographie X conventionnelle (détection d'un rayonnement centré autour de 50 keV, RQA5 norme IEC 62220-1, ou centrée sur 90keV, RQA9 norme IEC 62220-1) ; dans ces deux cas, l'épaisseur de la couche de pérovskite organique ou hybride organique/inorganique est épaisse pour absorber une part significative du rayonnement (typiquement de 0,1 mm à 2 mm, par exemple 1 mm),
- photovoltaïque, ou photo-détecteur UV, visible ou infrarouge, ou LED avec de faibles épaisseurs de couche de pérovskite organique ou hybride organique/inorganique (typiquement de 100 nm - 2µm, de préférence quelques centaines de nanomètres),
- détection rayonnement X dur ou gamma avec de fortes épaisseurs de pérovskite organique ou hybride organique/inorganique (typiquement de 1 mm à 10 mm, de préférence de 2 à 3 mm).

Le procédé de fabrication d'une couche 1 de pérovskite organique ou hybride organique/inorganique comprend les étapes suivantes :
a) fournir un substrat 10 et une cible organique ou hybride organique/inorganique 20,
b) positionner le substrat 10 et la cible 20, dans un four de sublimation à faible distance,
c) déposer une couche de pérovskite organique ou hybride organique/inorganique 1 sur le substrat 10 par sublimation de la cible 20.

Le procédé permet de former une couche 1 de matériau pérovskite (PVK) sur un substrat 10. L'épaisseur de la couche 1 peut aller de 10nm à 10mm en fonction des applications visées. La composition de la couche de pérovskite est homogène quelle que soit l'épaisseur de la couche formée.

De manière générale, cette invention s'applique pour toute pérovskite de formule chimique générale ABX₃, y compris des compositions mixtes telles que :
- A⁽¹⁾_{1-(y2+...+yn)}A⁽²⁾_{y2}...A⁽ⁿ⁾_{yn}B⁽¹⁾_{1-(z2+...+zm)}B⁽²⁾_{z2}...B^{(m)}_{zm}X⁽¹⁾_{3-(x2+...+xp)}X⁽²⁾ₓ₂...X^{(p)}ₓₚ avec y₂ et yₙ les proportions respectives de A⁽²⁾ et A⁽ⁿ⁾, z₂ et zₘ les proportions respectives de B⁽²⁾ et B^{(m)}, et x₂ et xₚ les proportions respectives de X⁽²⁾ et X^{(p)}, et
- A₂C¹⁺D³⁺X₆ (un matériau avec des mailles doubles).

Pour ces différents matériaux pérovskites, A représente un composé organique, un mélange de composés organiques ou un mélange de composé organique et de composé inorganique. Par composé organique, nous entendons tout composé contenant au moins l'élément carbone et un ou plusieurs des éléments suivants : hydrogène, halogène, oxygène, soufre, phosphore, silicium ou azote.

Par exemple, A représente :
- une molécule organique (par exemple CH₃NH₃⁺ (methylammonium MA) ou CH(NH₂)₂⁺ (formamidinium FA)), ou C(NH2)3⁺(guanidinium GA) - un mélange de molécules organiques (par exemple : MA₁₋ₓFAₓ avec 0<x<1),ou - un mélange de parties organique (par exemple MA, FA) et inorganique (par exemple Cs, Rb, K, Li, Na,...), (par exemple : Cs₁₋ₓFAₓ avec 0<x<1),
X est un anion, de préférence, un halogénure (par exemple Cl⁻, Br⁻, I⁻, F⁻...).

B peut être une molécule organique (telle que N-méthyl-1,4-diazabicyclo[2.2.2]octane) (MDABCO) ou N-hydroxy-N'-diazabicyclo[2.2.2]octonium (ODABC)), ou un élément inorganique (par exemple choisi parmi Pb, Sn, Ge, Hg et Cd), ou un mélange de molécule organiques, d'éléments inorganiques ou de molécules inorganiques et d'éléments organiques.

Il est également possible d'avoir de 2 à 5 éléments sur un des sites, sur deux des sites ou sur les trois sites A, B et X. Par exemple, on peut choisir un matériau avec X=ClₖBrₗI₁₋ₖ₋ₗ avec 0≤k,l≤1 et 0≤k+l≤1.

Selon une deuxième variante de réalisation avantageuse, la couche de pérovskite organique ou hybride organique/inorganique a pour formule A₂C¹⁺D³⁺X₆.

L'invention s'applique également à toutes autres compositions s'apparentant à des pérovskites :
- des matériaux de composition A₂C¹⁺D³⁺X₆ avec C et D sont des cations. C peut être choisi, par exemple, parmi Ag, Au, Tl, Li, Na, K, Rb et/ou D peut être choisi, par exemple, parmi Al, Ga, In, Sb, Bi et A et X choisis comme précédemment,
- des matériaux de composition A₂B⁴⁺X₆ comme par exemple Cs₂Te⁴⁺I₆, des matériaux de composition A₃B₂³⁺X₉ comme par exemple Cs₃Bi₂I_{g}, ou A₃¹⁺B₂³⁺X₆¹ou d'autres type de matériaux (Chalcogénides, Rudorffites...),
- Plus généralement des matériaux de composition A⁽¹⁾_{1-(y2+...+yr)}A⁽²⁾_{y2}...A⁽ⁿ⁾_{yn}B⁽¹⁾_{1-(z2+...+zm)}B⁽²⁾_{z2}...B^{(m)}_{zm}X⁽¹⁾_{3-(x2+...+xp)}X⁽²⁾ₓ₂...X^{(p)}ₓₚ

De préférence, on choisira :
- MAPbBr₃, notamment pour des applications médicales comme la mammographie (énergie ~ 18keV), et la radiologie (énergie ~ 50keV),
- MA₂AgBiBr₆ notamment pour et la radiologie (énergie ~ 50keV),
- Cs_{0.17}FA_{0.83}Pb(Br_{0.17}I_{0.83})₃ notamment pour le photovoltaïque.

Dans le cas où la cible 20 est de formule ABX₃, la cible 20 peut être formée d'un mélange de particules élémentaires A, B et X.

Selon d'autres modes de réalisation, la cible 20 de formule ABX₃ peut être formée :
- d'un mélange de particules binaires AX et BX₂,
- d'un mélange de particules AX, BX₂ et éventuellement ABX₃,
- de particules ABX₃, ce qui permet d'avoir directement la bonne composition et la bonne phase du matériau à sublimer; ces particules pourront, par exemple, être des petits monocristaux formés par voie liquide, par Bridgman ou autre solution.

Il est également possible d'utiliser des mélanges plus complexes comprenant plus de deux types de particules binaires.

C'est par exemple le cas pour les pérovskites mixtes (multi-anion, multi-cation). Par exemple pour former MA₂AgBiBr₆, il est possible de partir d'un mélange de 3 poudres binaires : MABr, BiBr₃ et AgBr.

Dans le cas où la cible 20 est de formule A₂C¹⁺D³⁺X₆, la cible peut être composée :
- d'un mélange de particules binaires AX, C¹⁺X et D³⁺X₃,
   - d'un mélange de particules AX, C¹⁺X et D³⁺X₃ et A'₂C¹⁺D³⁺X₆
   - de particules A₂C¹⁺D³⁺X₆, ce qui permet d'avoir directement la bonne composition et la bonne phase du matériau à sublimer.

De même, dans le cas de A₃¹⁺B₂³⁺X₆¹⁻, on pourra partir directement d'une poudre de A₃¹⁺B₂³⁺X₆¹⁻ .

D'autres compositions plus complexes et/ou mettant en jeu un plus grand nombre de précurseurs peuvent également être envisagées.

Selon un mode de réalisation particulier, la cible 20 forme une galette solide (autrement dit les particules sont agglomérées). Préférentiellement, la cible 20 est une galette solide de 1 à 10 mm d'épaisseur. Par exemple, elle a une épaisseur de 3 mm.

Selon un mode de réalisation particulier, la cible 20 est fabriquée à partir de cristaux de ABX₃. La cible peut être soit découpée aux dimensions adéquates dans un cristal de ABX₃ de dimensions supérieure, soit par assemblage de cristaux de taille inférieure (typiquement de taille millimétrique ou centimétrique). Une étape de découpe/polissage supplémentaire peut être nécessaire lors de l'assemblage des cristaux de taille inférieure afin d'assurer que ceux-ci sont bien jointifs et forment un pavage plan. Le (les) cristal(aux) utilisé(s) pour la fabrication de la cible peuvent être formés par voie liquide, par Bridgman ou autre solution. Par cristal, nous entendons un monocristal ou un polycristal (assemblage d'orientations cristallines).

Selon un autre mode de réalisation particulier, les particules de la cible 20 peuvent former un lit de poudres.

La taille caractéristique (ou la granulométrie) des particules formant la cible 20 va, par exemple, de 10 nm à 1000 µm, et de préférence de 20 µm à 100 µm.

Selon un mode de réalisation particulier, la cible 20 est formée d'un film de pérovskite organique ou hybride organique/inorganique déposé sur un substrat, de préférence compatible avec de hautes températures, par exemple sur un substrat en verre. Ce film peut être constitué de pérovskite de type ABX₃ comme MAPbBr₃.

Le film est continu. Le film est homogène.

Le film de la cible 20 peut être obtenu par dépôt CSS à partir d'une autre cible (dite cible intermédiaire) ou par toute autre méthode de dépôt, comme par exemple par croissance en solution ou par évaporation.

Un tel film peut servir pour former des couches fines, intermédiaires ou épaisses. L'épaisseur du film formant la cible 20 est supérieure ou égale à l'épaisseur de la couche à déposer 1. De préférence, l'épaisseur du film formant la cible 20 est strictement supérieure à l'épaisseur de la couche à déposer 1.

Par exemple, un film de 1 à 10mm, par exemple de 1,1 mm, peut être utilisé pour former une couche 1 de pérovskite organique ou hybride organique/inorganique de 1 mm d'épaisseur.

Dans une variante de mise en œuvre, l'épaisseur du film de la cible 20 est au moins 10 fois et encore plus préférentiellement au moins 100 fois supérieure à l'épaisseur la couche à déposer 1. Ce mode de réalisation est particulièrement avantageux pour former des couches 1 fines (typiquement ayant une épaisseur inférieure à 2 µm) de pérovskite organique ou hybride organique/inorganique. Avantageusement, la cible 20 peut servir pour plusieurs dépôts (par exemple pour au moins 3 dépôts et préférentiellement pour plus de 20 dépôts). L'épaisseur de la cible devra être supérieure à la somme des épaisseurs de dépôt visées.

La dimension de la cible 20, formée d'un lit de poudre ou de particules agglomérées, ou encore d'un film, peut aller, par exemple, de 1cm² à 1m².

La dimension de la cible 20 correspond à la taille du dépôt à réaliser. Par exemple, pour un dépôt de 40×40 cm², on utilise une cible de même dimension.

La cible 20 peut être un monobloc ou un ensemble d'éléments agencés de manière à former un pavage de la taille du substrat 10. Par exemple, pour un dépôt de 40x40 cm², il faudra un ensemble de cibles pour former un pavage de 40x40 cm².

Le substrat 10 sur lequel est déposée la couche 1 de pérovskite organique ou hybride organique/inorganique peut être en verre, en polyimide, par exemple en Kapton^{®}, ou encore en silicium. Le substrat peut être une matrice de détecteur TFT ou une matrice de détecteur CMOS. La nature du substrat dépend de l'application visée et des températures utilisées lors du procédé.

Le substrat 10 peut lui-même être positionné sur un support 11. Par exemple, on peut utiliser une matrice TFT sur un support en polyimide.

Selon un mode de réalisation avantageux, le substrat 10 peut être recouvert par une couche intermédiaire 12 (ou sous-couche) ou plusieurs couches intermédiaires.

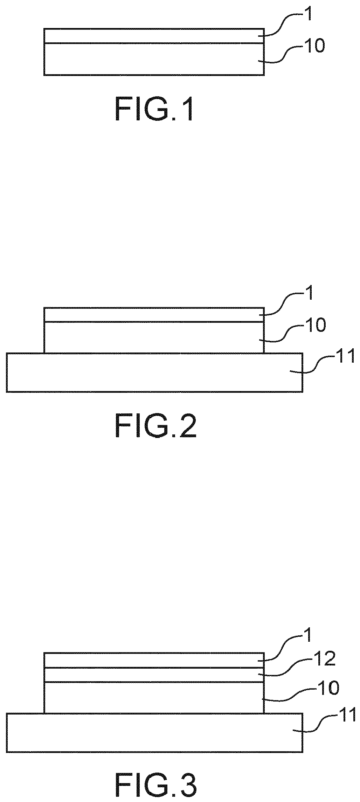

A l'issue de l'étape c), on peut donc obtenir un empilement comprenant et de préférence constitué par :
- un substrat 10 et une couche de pérovskite 1 (figure 1),
- un support 11, un substrat 10 et une couche de pérovskite 1 (figure 2),
- un substrat 10, une couche intermédiaire 12 et une couche de pérovskite 1,
- un support 11, un substrat 10, une couche intermédiaire 12 et une couche de pérovskite 1 (figure 3).

En particulier, la couche intermédiaire 12 peut permettre de former une électrode pour un dispositif envisagé et/ou de fournir une couche tampon avec un coefficient de dilatation thermique (CTE) proche de celui de la couche pérovskite à déposer

Selon une première variante de réalisation, la couche intermédiaire 12 est une couche de même nature que la couche de pérovskite organique ou hybride organique/inorganique à déposer, i.e. la couche intermédiaire 12 est une couche de formule ABX₃. Cette couche aide à la croissance de la couche formée à l'étape c). Elle peut notamment jouer non seulement le rôle de couche d'accroche, mais aussi et surtout d'aide à la cristallisation. La présence de la sous-couche en ABX₃ sur le substrat permet une homoépitaxie de la couche principale.

Selon une deuxième variante de réalisation, la couche intermédiaire 12 est en ABX₃:D avec D représentant un élément dopant dans la matrice ABX₃. D peut être un élément exogène placé en interstitiel ou substitutionnel, une lacune dans la matrice ABX₃ ou tout autre mécanisme de dopage. D peut par exemple être du Bi³⁺ ou du Sn⁴⁺ placé en substitutionnel par rapport au Pb²⁺. Ce dopage permet d'obtenir une sous-couche de dopage (p ou n) différent du dopage de la couche principale (elle-même dopée p, n ou intrinsèque). Le rôle de cette sous-couche dopée est d'assurer un meilleur contact électrique avec le reste du dispositif et/ou faciliter l'homoépitaxie de la couche principale.

Selon une troisième variante de réalisation, la couche intermédiaire 12 est en une pérovskite constituée d'élément partiellement ou totalement différent. Par exemple une sous couche en AB(X_{1-z}Y_{z})₃. Un alliage (ou une substitution des éléments) est possible sur un, plusieurs ou tous les sites A, B et X. On peut également envisager une sous-couche hybride organique-inorganique type CH₃NH₃PbX₃. Le but de la sous-couche est d'exhiber des propriétés optoélectroniques différentes (énergie de bande interdite, affinité électronique, potentiel d'ionisation) afin d'optimiser le fonctionnement du dispositif.

Selon une quatrième variante de réalisation, la couche intermédiaire 12 est de nature totalement différente. Il peut s'agir d'une couche cristalline ou d'une couche amorphe. Dans ce cas, le rôle envisagé de la sous-couche est de jouer le rôle de couche tampon afin de compenser la différence de coefficient de dilatation thermique entre la couche principale et le substrat. Cette couche devra être choisie en fonction du substrat, de son coefficient de dilatation thermique et de sa capacité à absorber les contraintes. Par exemple, cette sous-couche pourrait être :
- une pérovskite organique ou hybride organique/inorganique de type Ruddlesden-Popper ou Dion Jacobson comportant une partie de nature organique qui permettrait de relâcher les contraintes mécaniques résiduelles liées aux CTE différentiels,
- une couche polymère réticulée ou non réticulée,
- un mélange de polymère(s) et de pérovskite(s), ou de petite(s) molécule(s) organiques et de pérovskite(s),
- une couche mince polycristalline (<10µm) de pérovskite avec ou sans agent réticulant pour maintenir une cohésion entre les grains via des forces ioniques ou de Wan der Waals (exemples : dihydrochlorure de 1,6-diaminohexane (CAS : 6055-52-3)),
- une couche ou multi-couche comprenant des matériaux ductiles, type Zn, Pb, Al, Sn, ...
- une couche ou multi-couche de matériaux quelconques avec des CTE intermédiaires entre ceux de la PVK et du substrat. Le choix des matériaux dépend du couple substrat/PVK déposée,
- une multi-couche possédant des matériaux sous contrainte en compression/tension capable de compenser les contraintes en tension/compression dues à la dilatation thermique. Le choix des matériaux dépend du couple substrat/couche de PVK déposée.

La couche intermédiaire 12 peut jouer un ou plusieurs des rôles/buts précités. Par exemple une couche ABX₃:D déposée par évaporation peut à la fois servir de couche de contact électrique et permettre l'homoépitaxie de la couche principale.

Si la nature de la sous-couche est différente de la couche déposée lors de l'étape c) mais avec un paramètre de maille comparable, elle peut néanmoins favoriser la croissance de cette couche par hétéroépitaxie.

La couche intermédiaire a une épaisseur inférieure à l'épaisseur de la couche déposée lors de l'étape c). L'épaisseur de la couche intermédiaire peut aller de quelques nanomètres à quelques dizaines de microns. Typiquement, l'épaisseur de la couche intermédiaire fait de 0.1% à 50%, par exemple 5%, de l'épaisseur du dépôt principal.

La sous-couche peut être déposée de manière continue sur toute la surface, ou de manière localisée en utilisant des techniques de dépôt directe (jet d'encre, sérigraphie...) ou en utilisant les techniques de lithographie et photolithographie.

Une couche intermédiaire 12 en pérovskite peut être déposée par CSS (avec une cible différente), par évaporation sous vide, par voie liquide ou tout autre méthode de dépôt des PVK inorganique et hybride organique/inorganique. A titre illustratif et non limitatif, le dépôt par voie liquide peut être réalisé par dépôt à la tournette (ou « spin coating »), en solvant, par ablation laser pulsée (PLD « Pulsed laser Deposition ») ou par dépôt par bain chimique (CBD « Chemical Bath Deposition »).

Autrement, la couche intermédiaire 12 peut être déposée par des méthodes de dépôt de couches minces sous vide (évaporation, pulvérisation cathodique) ou par des méthodes de dépôt comme le dépôt par couches atomiques (ALD pour « Atomic Layer Deposition »), l'électrodéposition, ou la croissance en solution.

La couche intermédiaire 12 peut également être déposée à partir de la même cible que celle utilisée pour la couche principale de pérovskite (étape c). La composition de la cible 20 varie alors dans son épaisseur (autrement dit, la cible est formée de deux parties différentes, chacune des parties correspondant à une composition particulière). La partie supérieure de la cible est constituée des éléments constitutifs de la couche intermédiaire 12, la partie inférieure de la cible est constituée des éléments constitutifs de la couche principale 10. La partie supérieure de la cible est plus fine (0.1 µm-100µm) que sa partie inférieure (100 µm - 10 mm). Cette cible en bicouche peut par exemple être, par exemple, fabriquée en compactant des poudres différentes sur une cible déjà compactée, par implantation ionique dans une cible ou autre méthode.

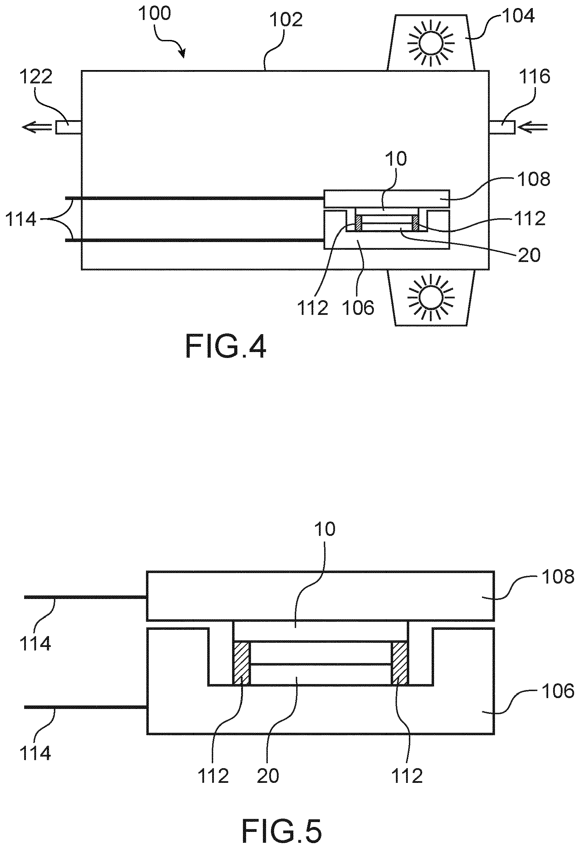

L'étape c) est réalisée avec un dispositif CSS classique 100 tel que celui représenté à titre illustratif et non limitatif sur les figures 4 et 5. Cependant, il pourrait s'agir de tout autre dispositif de CSS.

Le four CSS 100 comprend un réacteur 102 autour duquel est positionné un système de chauffage. Par exemple, il peut s'agir de lampes 104 (figure 4) ou de toute autre système de chauffage (résistance par exemple).

Le réacteur 102 peut être en quartz, en graphite, en métal.

Le réacteur 102 peut être tubulaire comme sur la figure 1.

Le four 100 comprend également un suscepteur 106 (aussi appelé bloc source) et un couvercle 108 (aussi appelé bloc substrat). Le suscepteur 106 et le couvercle 108 sont en des matériaux thermiquement conducteurs, pouvant résister à la pression, au vide et à de fortes températures. Ils sont, de préférence, en graphite.

Le substrat 10 et la cible 20 sont positionnés entre le suscepteur 106 et le couvercle 108.

De préférence, le substrat 10 est en contact direct avec le couvercle 108 qui maintient sa température à la valeur de consigne.

La cible 20 de PVK à déposer est disposée sur le suscepteur 106.

Le substrat 10 est à faible distance de la cible 20. Par faible distance, on entend une distance typiquement de 1 mm à 20 mm, préférentiellement de 1 mm à 7mm, par exemple de 1 mm à 5 mm ou de 3 mm à 5 mm. Notamment, on pourra choisir une distance de 2 mm. On choisira un compromis entre une distance suffisamment proche pour avoir une vitesse de dépôt élevée et une distance suffisante pour pouvoir maximiser et maintenir le gradient thermique au cours du dépôt.

Un ou plusieurs espaceurs 112 en matériau isolant thermique (par exemple verre, quartz, ou alumine) servent à maintenir le substrat 10 à faible distance de la cible 20.

Le couvercle 108 peut être maintenu plaqué sur le substrat par un système de fermeture dans le suscepteur 106 non représenté (par exemple une vis ou tout autre système de fixation).

Le suscepteur 106 et le couvercle 108 possèdent chacun un thermocouple 114 ou tout autre système (pyromètre, ...) pour mesurer et piloter leur température.

Un système de chauffage (lampe, résistances, ...) permet de réguler la température du suscepteur 106 (T_{cible}) et du couvercle 108 (T_{substrat}) dans une gamme pouvant aller de 20°C à 600°C. Des rampes de montée en température sont pilotables dans une gamme, par exemple, de 0,1°C/s à 10°C/s. Le suscepteur 106 (T_{cible}) et le couvercle 108 (T_{substrat}) peuvent être piloté par des rampes (ou séquences de rampes) de température, de manière indépendante. Ainsi, il est possible d'ajuster les cinétiques de sublimation de la cible et les températures de condensation sur le substrat de façon à bien contrôler la morphologie de la couche suivant l'épaisseur déposée. En particulier, ces paramètres peuvent jouer sur la dimension des grains de la couche polycristalline ainsi déposée sur le substrat.

Il est possible d'ajouter des dispositifs de refroidissement spécifique pour le couvercle 108 (par exemple, tuyauterie intégrée pour liquide de refroidissement, écran de protection contre le rayonnement du suscepteur, radiateurs

Le dispositif 100 est relié à un système à une arrivée de gaz inerte 116 (tel que de l'argon ou N₂).

Le dispositif 100 peut également être relié à une arrivée de gaz oxydant (tel que O₂) ou à une arrive de gaz réducteur (tel que H₂).

Le dispositif 100 comprend une sortie de gaz 122, reliée à un système de pompage permettant d'atteindre un vide P_{four} allant, par exemple, de 0,00001 Pa - 1 Pa. La valeur P_{four} dépend du four CSS utilisé.

Lors de l'étape c), la cible est sublimée. Le dépôt par sublimation se fait en chauffant le suscepteur 106 et le couvercle 108 sous vide.

Lors de l'étape c), la température du substrat T_{sub} est inférieure à la température de la cible T_{cible} afin de créer un gradient thermique. Lors de l'étape c), le substrat est, avantageusement, maintenu à une température contrôlée. Il en va de même pour la cible.

La différence de température T_{cible} - T_{sub} est de 10°C à 350°C, de préférence de 50°C à 300°C et encore plus préférentiellement de 100°C à 250°C, par exemple de 150°C.

Les températures visées dépendent du matériau à déposer et sont ajustées en fonction de son diagramme de phase. Par exemple, pour le matériau MAPbBr₃, on pourra choisir T_{cible} = 300°C (± 100°C) et T_{substrat} = 200°C (± 100°C).

On peut effectuer, par exemple, des rampes de montée en température comprises entre 0,2°C/s et 10°C/s, par exemple de 1°C/s.

Selon une première variante de réalisation, l'étape de dépôt (sublimation) est effectuée à basse pression (typiquement inférieure à 1Pa). Avantageusement, la pression lors de l'étape c) va de 0,001 Pa à 1 Pa. Par exemple, on peut choisir P_{four}= 0,01 Pa.

Pour réaliser l'étape c), on peut effectuer des cycles pompe/purge gaz neutre pour évacuer l'oxygène du dispositif 100 et le mettre à basse pression.

Selon d'autres variantes de réalisation, pour favoriser la croissance des grains (germination, nucléation puis croissance), il peut être intéressant de travailler lors de l'étape c) sous atmosphère oxydante ou sous atmosphère réductrice.

L'atmosphère oxydante peut être obtenue en fixant une pression partielle faible (de préférence de 0,1 à 10 Pa, par exemple de 1 Pa) en Ar:O₂ (1 at% < O₂ < 10 at%)) pendant cette étape.

L'atmosphère réductrice peut être obtenue en fixant une pression partielle faible (de préférence de 0,1 à 10 Pa, par exemple de 1 Pa), en Ar:H₂ (1 at% < H₂ < 10 at%)) pendant cette étape.

Le temps de dépôt dépend de l'épaisseur visée. Pour déposer des couches minces (50 nm - 5000 nm), les temps de dépôt sont de l'ordre de 5 min à 2h, par exemple de 30 min. Pour déposer des couches épaisses (50 µm - 5000 µm), les temps de dépôt sont de l'ordre de 30 min à 8h, par exemple de 4h.

Après l'étape c), la couche de pérovskite formée est refroidie. Le refroidissement peut être naturel ou piloté par des rampes. Un système de refroidissement rapide (par eau ou liquide réfrigérant dans des tuyaux insérés dans suscepteur et couvercle) est également envisageable.

Selon un mode de réalisation particulier, le procédé comprend une étape additionnelle à haute pression, entre l'étape b) et l'étape c).

Par haute pression, on entend une pression supérieure à 10³ Pa, par exemple de l'ordre de 10⁵ Pa. Cette étape est particulièrement avantageuse dans le cas de l'utilisation d'une cible 20 comprenant un mélange de poudres, par exemple un mélange de poudres AX et BX₂. En effet, cette étape à haute pression permet l'obtention in-situ de la phase ABX₃ (grâce à la réaction AX+BX₂ →ABX₃) avant la sublimation de la cible. Un dépôt de très bonne qualité est donc obtenu. Cette variante est également particulièrement intéressante dans le cas d'une cible 20 formée d'un lit de poudre puisqu'elle permet d'agglomérer les particules et/ou de compacter la cible.

Le procédé peut également comprendre, avant l'étape a), une étape au cours de laquelle on fabrique la cible 20 de formule ABX₃.

La fabrication de la cible nécessite de mettre en forme des particules de manière à former une cible.

Les particules peuvent être obtenues par broyage ou par co-broyage.

La mise en forme peut être réalisée en pressant les particules de manière à obtenir une cible solide.

Selon une première variante de réalisation, les particules formant la cible sont obtenues par broyage d'un matériau de formule ABX₃. L'étape de broyage permet d'ajuster la taille des particules. Le matériau de formule ABX₃ peut être obtenu par croissance cristalline, par synthèse chimique ou toute autre méthode de synthèse.

Selon une deuxième variante de réalisation, les particules formant la cible sont obtenues par co-broyage d'un premier matériau de formule AX et d'un deuxième matériau de formule BX₂.

Selon une troisième variante de réalisation, les particules formant la cible peuvent être obtenues par co-broyage de trois matériaux A, B et X.

Les quantités relatives des différents matériaux seront choisies de manière à former une cible de formule ABX₃.

L'étape de broyage ou de co-broyage peut être réalisée dans un broyeur planétaire à billes.

De préférence, les particules formant la cible 20 sont obtenues par mécanosynthèse. La mécanosynthèse consiste à réaliser un co-broyage très énergique de matériaux purs ou pré-alliés dans un broyeur à haute énergie, jusqu'à l'obtention d'une poudre dont les particules sont monophasées ou polyphasées. Par exemple, le mélange de AX et BX₂ peut conduire à l'obtention de particules monophasées (ABX₃) ou d'un mélange ABX₃ + AX+ BX₂.

Un broyage énergétique est induit par exemple par :
- une masse de billes importante par rapport à la masse de poudre (au moins 2 fois supérieure, par exemple 15 fois supérieure), et/ou
- une vitesse de rotation élevée (typiquement de 100 tours/min à 700 tours/min, par exemple 500 tours/min), qui dépend du broyeur utilisé ainsi que de la masse de billes et de poudres, et/ou
- un temps de broyage important (entre 10min et 5h, par exemple 1h).

Selon un autre mode de réalisation, les particules ne sont pas co-broyées avant de mettre en forme la cible. Par exemple, lorsque la poudre comprend un mélange de particules différentes, par exemple AX et BX₂, il est possible de supprimer la phase de co-broyage. Dans ce cas, la formation d'ABX₃ peut se faire :
- soit dans la cible avant sublimation (dans le four de CSS) lors de l'étape à haute pression suivant la réaction AX+BX₂ → ABX₃ - soit directement sur le substrat suivant la réaction AX+BX₂->ABX₃ après sublimation séparée de AX et BX_{2 ;} Il convient dans ce cas d'ajuster les quantités d'AX et BX₂ en fonction de leur température de sublimation afin de maintenir la composition ABX₃ finale dans le dépôt. Dans un cas particulier de l'invention, la composition de la cible n'est pas stœchiométrique, mais les conditions de dépôts et les vitesses relatives de dépôt des différents précurseurs conduisent à une couche stœchiométrique sur le substrat sur lequel se fait le dépôt.

L'avantage de cette variante est de supprimer l'étape de broyage, conduisant ainsi à un gain de temps et de coût.

Selon un mode de réalisation particulier, la poudre de formule ABX₃ est pressée pour former une galette (ou cible) solide. Autrement dit les particules sont agglomérées ou frittées.

Une presse manuelle peut être utilisée. La pression à appliquer est comprise entre 10⁵ Pa.cm⁻² et 10⁸ Pa.cm⁻², par exemple 10⁷ Pa.cm⁻².

En variante de la presse manuelle, on peut presser en chauffant (par exemple à T=250°C±200°C) pour améliorer la compacité de la cible et favoriser la formation ABX₃ dans la cible.

Le pressage en chauffant peut notamment se faire par frittage flash (ou SPS pour « Spark Plasma Sintering ») qui permet une bonne compacité en maintenant une granulométrie fine (cible plus homogène).

Selon un autre mode de réalisation particulier, l'étape de pressage n'est pas nécessaire si l'on souhaite utiliser un lit de poudres pour le procédé CSS. Dans ce cas, la quantité nécessaire de poudre (un mélange AX/BX₂ ou encore ABX₃) est disposée directement sur le suscepteur 106 ou sur un support positionné sur le suscepteur 106. Dans le cas du mélange AX/BX₂ il peut être nécessaire d'ajuster les quantités d'AX et BX₂ en fonction de leur température de sublimation afin de maintenir la composition ABX₃ finale dans le dépôt.

La suppression de l'étape de pressage représente un gain de temps et de coût.

La masse de poudre à utiliser pour former la cible dépend de la taille et de l'épaisseur de la cible souhaitée, par exemple on utilisera de 4 à 5 g.cm⁻³.

La manipulation de poudre se fait, préférentiellement, en boîte à gants sous atmosphère inerte (Ar ou N₂) avec un faible taux d'O₂ et H₂O.

Selon une autre variante de réalisation, la cible peut être fabriquée à partir de cristaux autosupportés de pérovskite ayant une dimension latérale allant de quelques mm à plusieurs cm. Ces cristaux peuvent être des monocristaux ou des polycristaux (plusieurs monocristaux imbriqués les uns dans les autres). Ces cristaux, seuls ou raboutés côte à côte sous forme de mosaïque, peuvent faire office de cible. Le cristal peut avoir la composition de la couche de pérovskite à former. Dans le cas où la cible est constituée d'au moins deux cristaux raboutés, leur composition peut être identique ou différente.

### Exemples illustratifs et non limitatifs de modes de réalisation :

Procédé de fabrication d'une couche épaisse de MAPbBr₃₋

Dans cet exemple, on fabrique, dans un premier temps, une cible ABX₃ de formule MAPbBr₃ de 10g ayant une épaisseur de 1.1 mm et une surface de 25 cm².

La cible est fabriquée à partir de particules de AX (MABr) et de particules de BX₂ (PbBr₂).

Les poudres de AX et les poudres de BX₂ sont disponibles dans le commerce. Elles ont une pureté supérieure à 99% (de 99% à 99,999%). Chacune de ces poudres est blanche.

L'ouverture des contenants des poudres et la manipulation de poudre se fait en boîte à gants sous atmosphère inerte (Ar ou N₂) avec un faible taux d'O₂ et H₂O.

Une masse définie de chaque poudre est prélevée de manière stœchiométrique pour que la composition finale du mélange soit ABX₃. Soit m_{T} la masse de la cible d'ABX₃ visée. Les masses respectives d'AX (m_{AX}) et de BX₂ (m_{BX}) à prélever sont donc :
m_{AX} = m_{T} × (M_{A}+M_{X})/(M_{A}+M_{B}+3M_{X})
m_{BX2} = m_{T} × (M_{B}+2M_{X})/(M_{A}+M_{B}+3M_{X})
avec M_{A}, M_{B}, et M_{X} sont les masses molaires des éléments A, B et X respectivement.

Ainsi, pour préparer une cible de 10 g de MAPbBr₃, il faudra prélever des masses de 2.338 g de MABr et 7.662 g de PbBr₂ respectivement. Leurs pressions de vapeur saturante à la température de dépôt visée ne soient pas trop éloignées.

De manière optionnelle, la composition de la cible peut s'écarter de la composition stœchiométrique exacte afin de compenser les vitesses de sublimation différentes (dû à des tensions de vapeur différente) des composées AX et BX₂. Par exemple pour sublimer du MAPbBr₃, il est possible de partir d'une cible de (MABr)ₓ(PbBr₂) avec 0<1<x. Les masses d'AX et BX₂ sont ajustées pour obtenir le x désiré.

Les deux poudres sont placées dans un bol de broyage (en acier inox, carbure de tungstène ou autre) avec une masse de billes de broyage m_{billes} telle que m_{billes}≤m_{T}≤30 × m_{billes} et de préférence la masse de billes de broyage 15 fois supérieure à la masse totale m_{T} de poudre. Le choix de la taille de bol est piloté par la quantité de poudre : on choisira, par exemple, le bol pour que l'ensemble des billes et de la poudre remplisse environ à 1/3 le bol. Le bol est hermétiquement fermé pour être placé dans un broyeur planétaire.

La vitesse de rotation v_{R} est élevée (~ 300 tours par minutes) et le temps de broyage est d'environ 1h.

La poudre ainsi obtenue est ensuite pressée pour former une galette solide. Une presse manuelle peut être utilisée. L'ordre de grandeur de la pression à appliquer est de 10⁷ Pa.cm⁻². La masse de poudre utilisée est d'environ 4.5 g.cm⁻³.

Le dépôt de la couche épaisse d'ABX₃ se fait ensuite dans un four de CSS classique.

Des cycles pompe/purge Ar du four sont effectués pour évacuer l'oxygène puis le four est mis à basse pression (typiquement à une pression 0.001 Pa < P < 1 Pa, par exemple 0.1 Pa).

Le dépôt par sublimation se fait en chauffant suscepteur 106 et couvercle 108, avec T_{cible} = 300°C (± 100°C) et T_{substrat} = 200°C (± 100°C) et les rampes de montée en température sont comprises entre 0.2°C/s et 10°C/s. Les rampes de montée en température sont, par exemple, de 1°C/s.

On utilise une cible circulaire et un espaceur ayant un trou traversant de même dimension que la cible.

Le temps de dépôt dépend de l'épaisseur visée. Pour des applications de détection de rayon X pour le médical, les épaisseurs visées sont de 100 µm à 2 mm. On choisira en conséquence des temps de dépôt de 15 min à 5 h.

Si l'on rajoute une étape à haute pression, avant l'étape c), on peut réaliser le cycle suivant :
- étape haute pression : T_{cible} ~ 150°C, T_{substrat} ~ 100°C, P_{four}= 10⁵ Pa en Ar (> 10³ Pa), durée 30 min,
- étape c) : T_{cible} ~ 300°C, T_{substrat} ~ 200°C, P_{four}= 0.1 Pa en Ar (< 10 Pa), durée 30 min.

### Procédé de fabrication d'un détecteur de rayon X pour la mammographie (dépôt direct):

Les détecteurs utilisés pour la mammographie font typiquement 20x24 cm² et sont optimisés pour détecter le rayonnement à 18-20 keV (norme IEC 62220-1-2:2007).

Pour cette application, on peut envisager un substrat souple, par exemple une matrice de TFT déposée sur un support polyimide.

Le procédé de fabrication comprend les étapes suivantes :
- Fournir une matrice TFT sur polyimide ; pas des pixels de la matrice TFT : 75µm.
- Déposer une (ou une superposition de) couche pouvant bloquer les électrons (par exemple NiOx ou AlOx) par ALD (« Atomic Layer Deposition ») ou par toute autre méthode comme par exemple par évaporation, pulvérisation cathodique, ou encore par dépôt par voie liquide ; à titre d'exemple, on peut déposer un polymère, tel que le PTAA ou le Poly[bis(4-phényl) (2,4,6-triméthylphényl)amine), par dépôt à la tournette (« spin-coating »), ou encore
-une molécule par exemple Spiro-OMeTAD (CAS : 207739-72-8) par évaporation sous vide.
-- Fabriquer 16 cibles de MAPbBr₃ de surface 5x6 cm² et de 0,7 mm d'épaisseur en mélangeant 36 g de MABr et 118 g de PbBr₂ dans un bol de broyage avec 600 g de billes acier pendant 2h à 500 tours/min puis en pressant successivement les 16 cibles dans une presse automatique avec une pression de 3×10⁸ Pa.
- Positionner les 16 cibles dans un four graphite de dimension 20 × 24 cm² à 5 mm du substrat. Le substrat polyimide/TFT peut être fixé directement sur le couvercle (fixation mécanique) pour prévenir une flèche du à son manque de rigidité).
- Déposer une couche de MAPbBr₃ de 500 µm d'épaisseur par CSS avec les conditions suivantes : 300°C (cible)/225°C (substrat) pendant 1h30 à P=0,01 Pa.
-Déposer une (ou une superposition de) couche bloqueur de trous (TiO₂:Mg, Nb₂O₅, CdS, C60, 60PCBM, SnO₂, ZnO...) et une électrode supérieure (par exemple en métal, oxyde transparent conducteur, ...).

### Procédé de fabrication d'un détecteur de rayon X pour la mammographie (dépôt indirect):

Les détecteurs utilisés pour la mammographie font typiquement 20x24 cm² et sont optimisés pour détecter le rayonnement à 18-20 keV (norme IEC 62220-1-2:2007).

Pour cette application, on peut envisager un substrat rigide, par exemple une matrice de TFT déposée sur un support verre.

Le procédé de fabrication comprend les étapes suivantes :
- Fournir un substrat verre (ou tout autre substrat ayant des propriétés de perméation à l'eau liquide et la vapeur d'eau).
- Déposer une électrode métallique plein champ susceptible de bloquer les électrons. Par exemple 100nm de Pt.
- Fabriquer 16 cibles de MAPbBr₃ de surface 5×6 cm² et de 0,7 mm d'épaisseur en mélangeant 36 g de MABr et 118 g de PbBr₂ dans un bol de broyage avec 600 g de billes acier pendant 2h à 500 tours/min puis en pressant successivement les 16 cibles dans une presse automatique avec une pression de 3×10⁸ Pa.
- Positionner les 16 cibles dans un four graphite de dimension 20 × 24 cm² à 5 mm du substrat. Le substrat verre/Pt peut être fixé directement sur le couvercle (fixation mécanique) pour prévenir une flèche due à son manque de rigidité).
- Déposer une couche de MAPbBr₃ de 500 µm d'épaisseur par CSS avec les conditions suivantes : 300°C (cible)/225°C (substrat) pendant 1h30 à P=0,01 Pa.
- Fournir une matrice TFT sur verre; pas des pixels de la matrice TFT : 75µm.
- coupler mécaniquement et électriquement le substrat verre/Pt/500µm de MAPbBr₃, sur la matrice TFT sur verre. Le couplage se fera à l'aide d'une colle conductrice (exemple : mélange EPOTEK 301 et 320), de bumps conducteurs, d'encre conductrice déposée localement (par exemple par sérigraphie), d'un film conducteur anisotrope (ACF) ou tout autre technique connue de l'homme de l'art.
- Dans une variante, une matrice de pixels peut être déposée sur la couche de MAPbBr₃ avant le couplage avec la matrice TFT. Dans ce cas, les pixels de la matrice TFT sont alignés avec les pixels de la matrice sur MAPbBr₃.

### Procédé de fabrication d'un imageur pour la radiographie X (main, thorax, articulation, fracture,...) :

Les imageurs pour la radiographie X sont de dimension 42x42 cm² et le rayonnement utilisé est centré autour de 50 keV (RQA5 norme IEC 62220-1).

Le procédé comprend les étapes successives suivantes :
- Fournir un support rigide (verre) ou souple (polyimide) sur lequel est déposé une matrice de TFT (pas des pixels 180 µm) ainsi qu'une (ou une superposition de) couche bloqueur d'électrons.
- Préparer 36 cibles carrées de 7×7 cm² de 1 mm épaisseur (soit environ 800 g de poudre : 300 g MABr, 515 g PbBr₂). Cobroyage des poudres avec une masse de billes 10 fois supérieure pendant 1h à 300 tours/min.
- Positionner les cibles et l'empilement support/substrat dans le four CSS, un espaceur maintenant le substrat à 2 mm des cibles.
- déposer une couche active de 0,8 mm de MAPbBr₃ avec les conditions suivantes : 300°C (cible)/225°C (substrat) pendant 2h à P=0,01 Pa.
- Déposer une (ou une superposition de) couche bloqueur de trous (TiO₂:Mg, Nb₂O₅, CdS, ...) et une électrode supérieure (par exemple en métal, oxyde transparent conducteur, ...).

### Procédé de fabrication d'un imageur pour l'imagerie X en temps réel - pose d'une endoprothèse artérielle (« stent » cardiaque) par exemple :

Les imageurs pour l'imagerie X en temps réel sont de dimensions réduites (21×21 cm²) mais le rayonnement utilisé de 60keV est plus énergétique (RQA9, norme IEC 62220-1). L'architecture du détecteur est semblable (en réduisant les dimensions des cibles et four pour adapter à la taille visée), l'épaisseur de la couche de MAPbBr₃ est d'environ 1,2 mm. L'épaisseur des cibles est donc de 1,5 mm et le temps de dépôt environ 2h30.

### Procédé de fabrication d'un module photovoltaïque à base de PVK inorganique (notamment la partie supérieure d'un module tandem Si à hétérojonction/PVK à large bande d'énergie interdite) :

Les épaisseurs de matériaux visées, relativement faibles (entre 100 nm et 2 µm), nécessitent des temps de dépôts plus courts et des températures de dépôt plus faibles. Le dépôt étant plus fin, il peut être obtenu à partir d'un lit de poudres. Par ailleurs, la surface du substrat (et donc de l'ensemble du four et suscepteur est plus importante) : typiquement 60 cm × 120 cm. On peut par exemple (exemple non restrictif) considérer le Cs_{0.17}FA_{0.83}Pb(Br_{0.17}I_{0.83})₃ comme matériau absorbeur. Le procédé décrit uniquement le dépôt des différentes couches; la partie mise en module standard (par interconnexion P1-P3-P3 par exemple) n'est pas décrite.

Le procédé s'effectue de la manière suivante :
- fournir un substrat : un module à hétérojunction de Si de haute performance terminé par une couche d'ITO,
- déposer une couche de transport d'électron (type NiO déposée par voie liquide, ALD ou autre),
- fabriquer la cible en cobroyant, à 500 tour/min, trois poudres de CsBr, FAI et PbI₂ afin d'obtenir une poudre comprenant les éléments dans la stœchiométrie visée,
- fabriquer 50 cibles de 12×12 cm² de 1 mm d'épaisseur. Les cibles peuvent servir pour plusieurs dépôts.
- déposer la couche de Cs_{0.17}FA_{0.83}Pb(Br_{0.17}I_{0.83})₃ par CSS : T_{cible} ~ 275°C (±50°C), T_{substrat} ~ 200°C (±50°C), P_{four}= 0.1 Pa en Ar (< 10 Pa), durée 15 min ; sublimation de 400 nm de Cs_{0.17}FA_{0.83}Pb(Br_{0.17}I_{0.83})₃
- déposer une couche de transport de trous (par exemple de type Spiro-OMeTAD (CAS : 207739-72-8) ou PTAA (Poly[bis(4-phényl) (2,4,6-triméthylphényl)amine)),
- Déposer une électrode en ITO, d'une couche anti-réflechissante et de grilles.

### Procédé de fabrication d'un scintillateur pour détecter le rayonnement gamma pour des applications médicales (exemple de la scintigraphie, rayonnement à 140 keV) :

Les scintillateurs sont des dispositifs de détection indirecte du rayonnement : celui-ci est transformé en lumière visible qui est à son tour capté par un photo-détecteur. L'utilisation d'un scintillateur peut se faire aussi bien pour la détection de rayonnement X (10² - 10⁵ eV) ou gamma (> 10⁵ eV). Nous donnerons ici un exemple de scintillateur pour la détection gamma, mais le principe est le même pour la détection X.

Les détecteurs de rayonnement gamma sont utiles dans de nombreux domaines : le médical (la tomographie) mais aussi le domaine industriel (inspection non destructive, système de sécurité), le domaine géophysique (analyse nature du sol pour la recherche pétrolière), le domaine de la sécurité publique (contrôle des bagages, véhicules), le domaine de la recherche fondamentale.

Nous allons plus particulièrement décrire le procédé de fabrication d'un scintillateur pour détecter le rayonnement gamma pour des applications médicales (exemple de la scintigraphie, rayonnement à 140 keV). Les imageurs font 40×40 cm².

Le procédé comprend les étapes suivantes :
- Fournir une matrice de TFT sur un support rigide (verre) sur laquelle est déposée une matrice de photo-détecteur organique ou silicium amorphe.
- Déposer une couche de MAPbBr₃ d'une épaisseur de 2 mm par CSS. La même méthode de dépôt est utilisée que pour le détecteur de rayon X pour la mammographie (pavage de 25 cibles 6×6 cm²) de 2,5 mm d'épaisseur. Le temps de dépôt est compris entre 3h et 4h.
- Déposer par pulvérisation cathodique une couche protectrice en aluminium.

### REFERENCES

[1] Dunlap-Shohl et al., Synthetic approaches for halide perovskite thin films. Chemical reviews, 2018. 119(5): p. 3193-3295.
[2] Wang et al., Structural and photophysical properties of methylammonium lead tribromide (MAPbBr3) single crystals. Scientific reports, 2017. 7(1): p. 1-14.
[3] Ye et al., Metal-free three-dimensional perovskite ferroelectrics. Science, 2018. 361(6398): p. 151-155.
[4] WO 2017/031193 A1

## Revendications

1. Procédé de dépôt par sublimation à faible distance d'une couche de pérovskite organique ou hybride organique/inorganique (1) sur un substrat comprenant les étapes suivantes :
a) fournir un substrat (10) et une cible (20) organique ou hybride organique/inorganique,
b) positionner le substrat (10) et la cible (20), dans un four de sublimation à faible distance (100), la cible (20) étant de préférence à une distance de 1 à 5 mm du substrat (10),
c) déposer une couche de pérovskite organique ou hybride organique/inorganique (1) sur le substrat (10) par sublimation de la cible (20),
l'écart de température entre la cible (20) et le substrat (10) étant, de préférence, compris entre 10°C et 350°C, encore plus préférentiellement entre 50°C et 200°C,
l'épaisseur de la couche de pérovskite organique ou hybride organique/inorganique (1) déposée étant, de préférence, comprise entre 10 nm et 5000 µm.

2. Procédé selon la revendication 1, **caractérisé en ce que** la couche de pérovskite organique ou hybride organique/inorganique (1) a pour formule ABX₃
avec
A un composé organique, un mélange de composés organiques ou un mélange de composé organique et de composé inorganique,
B un élément simple inorganique, une molécule organique ou un mélange de plusieurs éléments inorganiques et/ou de molécules organiques,
et X un anion, de préférence un halogénure.

3. Procédé selon la revendication 2, **caractérisé en ce que** la couche de pérovskite organique ou hybride organique/inorganique (1) est en MAPbBr₃.

4. Procédé selon la revendication 1, **caractérisé en ce que** la couche de pérovskite organique ou hybride organique/inorganique (1) a pour formule A₂C¹⁺D³⁺X₆
avec A un composé organique, un mélange de composés organiques ou un mélange de composé organique et de composé inorganique,
C et D des cations,
et X un anion, de préférence un halogénure.

5. Procédé selon la revendication 4, **caractérisé en ce que** la couche de pérovskite organique ou hybride organique/inorganique a pour formule MA₂AgBiBr₆.

6. Procédé selon la revendication 1, **caractérisé en ce que** la couche de pérovskite organique ou hybride organique/inorganique (1) a pour formule A⁽¹⁾_{1-(y2+...+yn)}A⁽²⁾_{y2}...A⁽ⁿ⁾_{yn}B⁽¹⁾_{1-(z2+...+zm)}B⁽²⁾_{z2}...B^{(m)}_{zm}X⁽¹⁾_{3-(x2+...+xb)}X⁽²⁾ₓ₂...X^{(p)}ₓₚ
avec A un composé organique, un mélange de composés organiques ou un mélange de composé organique et de composé inorganique
B un élément simple inorganique, une molécule organique ou un mélange de plusieurs éléments inorganiques et/ou de molécules organiques,
X un anion, de préférence, un halogénure.

7. Procédé selon la revendication 6, **caractérisé en ce que** la couche de pérovskite organique ou hybride organique/inorganique a pour formule Cs_{0.17}FA_{0.83}Pb(Br₀.₁₇I_{0.83})₃.

8. Procédé selon l'une quelconque des revendications 2 à 7, **caractérisé en ce que** la cible (20) comprend des particules de la même formule que la couche déposée.

9. Procédé selon l'une quelconque des revendications 2 à 7, **caractérisé en ce que** la cible (20) comprend un mélange de particules binaires de différentes natures, par exemple un mélange MABr, BiBr₃ et AgBr, le mélange pouvant en outre comprendre des particules tertiaires, par exemple la cible comprend des particules de formule AX, de particules de formule BX₂ et éventuellement des particules de formule ABX₃.

10. Procédé selon l'une des revendications 8 et 9, **caractérisé en ce que** la cible (20) fournie à l'étape a) est obtenue selon les étapes suivantes
- mécanosynthèse par co-broyage d'un premier matériau de formule AX et d'un deuxième matériau de formule BX₂ de manière à obtenir une poudre de formule ABX₃,
- pressage de la poudre de formule ABX₃ pour obtenir une cible solide de formule ABX₃.

11. Procédé selon l'une des revendications 8 et 9, **caractérisé en ce que** la cible (20) fournie à l'étape a) est obtenue selon les étapes suivantes :
- fabrication d'un matériau de formule ABX₃ par synthèse chimique, croissance cristalline ou tout autre mécanisme de synthèse puis broyage pour obtenir une poudre de formule ABX₃,
- pressage de la poudre de formule ABX₃ pour obtenir une cible solide de formule ABX₃.

12. Procédé selon l'une quelconque des revendications précédentes, **caractérisé en ce que**, avant l'étape c), le procédé comprend une étape additionnelle au cours de laquelle la cible (20) est chauffée à une température allant de 50°C à 500°C et est soumise à une pression supérieure à 10³ Pa.

13. Procédé selon l'une quelconque des revendications précédentes, **caractérisé en ce que**, avant l'étape c), le procédé comprend une étape au cours de laquelle une couche intermédiaire (12), de nature identique ou différente à la couche de pérovskite organique ou hybride organique/inorganique (1), est déposée sur le substrat (10).

14. Empilement comprenant un substrat (10) et une couche de pérovskite organique ou hybride organique/inorganique (1) obtenue par le procédé selon l'une quelconque des revendications 1 ou 5 à 13, la couche de pérovskite organique ou hybride organique/inorganique étant en MAPbBr₃, en Cs_{0.17}FA_{0.83}Pb(Br_{0.17}I_{0.83})₃ ou en MA₂AgBiBr₆ et ayant une épaisseur de 1 mm à 10 mm.

15. Utilisation d'un empilement tel que défini dans la revendication 14, pour la détection des rayonnements X et gamma.
